Europäisches Patentamt

European Patent Office

Office européen des brevets

(11) Publication number:

**0 396 478**
**A2**

## (12) EUROPEAN PATENT APPLICATION

(21) Application number: **90420208.2**

(51) Int. Cl.⁵: **H01L 39/24**

(22) Date of filing: **27.04.90**

(30) Priority: **04.05.89 US 347604**

(43) Date of publication of application:
**07.11.90 Bulletin 90/45**

(84) Designated Contracting States:
**AT BE CH DE DK ES FR GB GR IT LI LU NL SE**

(71) Applicant: **EASTMAN KODAK COMPANY**
**343 State Street**
**Rochester, New York 14650(US)**

(72) Inventor: **Leiental, Mark, c/o EASTMAN**
**KODAK COMPANY**

**Patent Department 343 State Street**
**Rochester New York 14650(US)**
Inventor: **Romanofsky, Henry J., c/o EASTMAN**
**KODAK COMPANY**
**Patent Department 343 State Street**
**Rochester New York 14650(US)**

(74) Representative: **Parent, Yves et al**
**Kodak-Pathé Département Brevets et**
**Licences Centre de Recherches et de**
**Technologie Zone Industrielle**
**F-71102 Chalon-sur-Saône Cédex(FR)**

(54) **Processes of forming conductive films and articles so produced.**

(57) A process is disclosed of forming on a substrate a conductive film having a $T_c$ of at least 110° K. A bismuth mixed alkaline earth copper oxide is employed approximating the theoretical stoichiometry required to form a crystalline conductive phase exhibiting a 37Å crystal cell c axis, but with a higher proportion of bismuth (or bismuth in combination with lead). The higher proportion of bismuth (or bismuth in combination with lead) results in improved conversion to the 37Å c axis phase on firing. Bismuth rich conductive articles produced by the process are also disclosed.

FIG. I

## PROCESSES OF FORMING CONDUCTIVE FILMS AND ARTICLES SO PRODUCED

The invention relates to conductive articles and processes for their formation. Specifically, the invention relates to a process of forming an article containing a film exhibiting a high superconducting transition temperature.

The term "superconductivity" is applied to the phenomenon of immeasurably low electrical resistance exhibited by materials. Until recently superconductivity had been reproducibly demonstrated only at temperatures near absolute zero. As a material capable of exhibiting superconductivity is cooled, a temperature is reached at which resistivity begins to decrease (conductivity begins to increase) markedly as a function of further decrease in temperature. This is referred to as the superconducting onset transition temperature or, in the context of superconductivity investigations, simply as the onset critical temperature $(T_c)$. $T_c$ provides a conveniently identified and generally accepted reference point for marking the onset of superconductivity and providing temperature rankings of superconductivity in differing materials. The highest temperature at which superconductivity (i.e., zero resistance) can be measured in a material is referred to as the onset superconductivity temperature $(T_o)$.

H. Maeda, Y. Tanaka, M. Fukutomi, and Y. Asano, "A New High $T_c$ Superconductor Without a Rare Earth Element", Japanese Journal of Applied Physics, Vol. 27, No. 2, pp. L209 & L210, first reported that at least one compound of bismuth, strontium, calcium, copper, and oxygen had been found to be superconducting.

One of the difficulties that has arisen in attempting to form films of bismuth mixed alkaline earth copper oxides that are superconducting at the highest attainable temperatures is that the conductive films are comprised of a mixture of different crystalline phases. Investigations have suggested that there are at least two bismuth mixed alkaline earth copper oxide crystalline phases present both having a pseudotetragonal crystal structure with crystal cell a and b axes of 5.4Å, but differing in the length of their crystal cell c axes.

The less desirable of these phases, exhibiting a $T_c$ 85° K, appears to be formed of an oxide containing bismuth strontium calcium and copper in the proportions $Bi_2Sr_2CaCu_2$. This lower onset $T_c$ superconductive phase is also referred to as the BSCCO-2212 phase. This crystalline phase can be identified by a crystal cell 30.7Å c axis and an X-ray diffraction angle of 5.8° for the (002) line. Note that the ratio of copper to the alkaline earth elements is 0.67.

A more desirable phase, exhibiting a higher $T_c$ of 110° K, appears to be formed of an oxide containing bismuth strontium calcium and copper in the proportions $Bi_2Sr_2Ca_2Cu_3$. This higher $T_c$ phase is also referred to as the BSCCO-2223 phase. This crystalline phase can be identified by a crystal cell 37Å c axis and an X-ray diffraction angle of 4.9° for the (002) line. Note the higher ratio of copper to the alkaline earth elements.

H. Nobumasa, K. Shimizu, Y. Kitano, and T. Kawai, "High $T_c$ Phase of Bi-Sr-Ca-Cu-O Superconductor", Japanese Journal of Applied Physics, Vol. 27, No. 5, May 1988, pp. L846-L848, report success in preparing bulk bismuth stronium calcium copper oxides having superconducting properties. The Bi:Sr:Ca:Cu atomic ratios employed were 1:1:1:2. When furnace heating times were extended to 80 hours a complete transition to the 110° K $T_c$ phase was reported.

T. Yoshitake, T. Satoh, Y. Kubo, and H. Igarashi, "Preparation of Thin Films by Coevaporation and Phase Identification in Bi-Sr-Ca-Cu-O System", Japanese Journal of Applied Physics, Vol. 27, No. 6, June 1988, pp. L1089-L1091, reported successful formation of superconductive bismuth strontium calcium copper oxide films by evaporative deposition. A film with a composition $Bi_{2.0}Sr_{1.8}Ca_{2.3}Cu_{2.3}O_x$ was reported to exhibit superconductivity above 100° K.

It is an object of this invention to provide on a substrate a bismuth mixed alkaline earth copper oxide conductive film having a higher proportion of a crystalline phase having a $T_c$ of at least 110° K.

In one aspect this invention is directed to a process of forming on a substrate a conductive film having a $T_c$ of at least 110° K comprising

forming a bismuth mixed alkaline earth copper oxide on the substrate satisfying the ratio:

Cu:IIA is > 0.70

where

IIA represents atoms of alkaline earth elements and

converting at least a portion of the bismuth mixed alkaline earth copper oxide to a crystalline conductive phase exhibiting 5.4Å, 5.4Å, and 37Å crystal cell a, b, and c crystal axes, respectively.

The process is characterized in that the proportion of the film accounted for by the 37Å crystalline conductive phase is increased by increasing the proportion of bismuth or bismuth in combination with lead in the bismuth mixed alkaline earth copper oxide to satisfy the metal ratio:

M:Cu is > 1.00
where
M is bismuth and 0 to 50 percent lead, based on bismuth and lead combined.

In another aspect the invention is directed to an article comprised of a substrate bearing a conductive film having a $T_c$ of at least 110°K containing a bismuth mixed alkaline earth copper oxide satisfying the ratio:

Cu:IIA is> 0.70

where IIA represents atoms of alkaline earth elements, at least a portion of the oxide being present as a crystalline conductive phase exhibiting 5.4Å, 5.4Å, and 37Å crystal cell a, b, and c crystal axes, respectively.

The article is characterized in that the ratio of bismuth or bismuth and lead combined to copper satisfies the ratio:

M:Cu is > 1.00
where
M is bismuth and 0 to 50 percent lead, based on bismuth and lead combined.


Brief Description of the Drawings

Figures 1 and 3 are plots of relative intensity versus diffraction angle from the (002) line;
Figure 2 is a plot of relative resistance versus temperature; and
Figure 4 is a plot of transition depth at 110°K versus sintering temperature in °C.


Description of Preferred Embodiments

The invention relates to a compositionally altered preparation of a bismuth mixed alkaline earth copper oxide film on a substrate and to articles produced by the process. It has been discovered that the proportion of a higher onset transition superconducting phase [$T_c$ = 110°K, pseudotetragonal crystal cell c axis = 37Å, X-ray diffraction angle = 4,9° for the (002) line] of the bismuth mixed alkaline earth copper oxide film can be increased in relation to the lower onset transition superconducting phase [$T_c$ = 85°K, pseudotetragonal crystal cell c axis = 30.7Å, X-ray diffraction angle = 5.8° for the (002) line] by increasing the proportion of bismuth or a combination of bismuth and lead in relation to copper in a metal oxide mixture present prior to firing to achieve conversion of the metal oxide mixture to its conductive crystalline form. (Except as otherwise specifically noted, the term "conductive" is used to mean electrically conductive.)

Since the higher onset transition phase of bismuth mixed alkaline earth copper oxides, typically BSCCO, is recognized to exhibit a theoretical stoichiometry of 2223, the practice prior to the present invention as to been to mix bismuth, strontium, calcium, and copper oxides in the approximate proportions of BSCCO-2223. Thus, the ratio:

(I) Cu:IIA is > 0.70,

where IIA represents atoms of alkaline earth elements, is higher than in BSCCO-2212, wherein the ratio of Cu:IIA is only 0.67.

It was the first discovery of this invention that the formation of the higher onset transition phase is enhanced by increasing the atomic ratio of bismuth to copper in the oxide mixture prior to firing. (Except as otherwise specifically indicated all ratios and percentages throughout this disclosure are on an atomic basis.) Specifically, the mixed metal oxides of this invention satisfy the relationship:

(II) Bi:Cu > 1.00

It other words, the invention employs a greater than 33 percent excess of bismuth over that which is necessary to satisfy the theoretical BSCCO-2223 stoichiometry.

In subsequent investigations it was discovered that a significant enhancement of the higher onset transition phase can be realized when lead was substituted for a portion of the bismuth. Thus, in a more general form, the advantages of the invention are realized when the mixed metal oxides of this invention satisfy the relationship:

(III) M:Cu > 1.00

where

M is bismuth and from 0 to 50 percent lead, based on bismuth and lead combined.

As demonstrated in the Examples below, the presence of lead, when the proportion of bismuth and lead together are increased, has the advantage of increasing the range of crystallization conditions capable of maximizing the formation of the higher onset transition phase. Measurements indicate that by so employing lead in combination with bismuth the conductive film can exhibit superconductivity ($T_o$) at temperatures above 85° K, which indicates that the proportion of the higher onset transition phase has been increased to such an extent that this phase itself forms a continuous current conduction path through the conductive film. The presence of lead, when relationship III is satisfied, broadens the range of preparation conditions resulting in films exhibiting superconductivity ($T_o$) or near superconductivity at temperatures above 85° K. It is specifically preferred, when relationship III is satisfied, to incorporate at least 5 mole percent lead, based on lead and bismuth, in the mixed metal oxide composition prior to crystallization. Optimally the mixed metal oxide contains from 10 to 40 mole percent lead, based on lead and bismuth. When relationship III is not satisfied, the addition of lead slightly reduces the proportion of the higher transition phase in the conductive film.

In relationship III above, the preferred ratio of M:Cu is in the range of from 3.1:3 to 10:3 and optimally from 3.15:3 to 6:3. Stoichiometric excesses of bismuth in relation to copper have not been observed to be detrimental. It is believed that bismuth stoichiometric excesses can be at least partially removed by volatilization during firing.

The mixed alkaline earth oxides can be selected and employed in the same proportions in relation to copper that have heretofore been employed in forming conventional higher onset transition phase bismuth mixed alkaline earth copper oxide crystalline materials. Typically the mixed alkaline earth oxides are mixtures of strontium and calcium oxides, although from 0 to 10 percent barium, based on barium and strontium combined, can be substituted for strontium. Strontium and the strontium and barium mixture are to a degree interchangeable with calcium in the higher onset transition crystalline phase.

In a preferred form the mixed metal oxides present before firing can satisfy the metal relationship:

(IV)        $M_aIIA_bCu_3$

where

M is as previously defined;

a is from 3.1 to 10, preferably 3.15 to 6;

IIA is a combination of the alkaline earth elements A and Ca in a ratio of from 1:3 to 3:1;

A is strontium and 0 to 10 percent barium, based on barium and strontium combined; and

b is from 3.5 to 4.3.

Any conventional technique heretofore taught for forming a mixture of bismuth, alkaline earth, and copper oxides on a substrate for crystallization can be employed to form bismuth or bismuth and lead mixed alkaline earth copper oxide (hereinafter also referred to as M-IIA-C-O) layers of this invention. For example, the metal oxide deposition procedure of Yoshitake, T. Satoh, Y. Kubo, and H. Igarashi, "Preparation of Thin Films by Coevaporation and Phase Identification in Bi-Sr-Ca-Cu-O System", Japanese Journal of Applied Physics, Vol. 27, No. 6, June 1988, pp. L1089-L1091, cited above, can be employed.

The present invention is fully applicable to the techniques of forming thick (>5μm) film M-IIA-C-O superconductive articles disclosed by Strom European Serial No. 89420415.5, filed Dec. 22, 1989, titled SUPERCONDUCTING THICK FILMS FOR HYBRID CIRCUITRY APPLICATIONS, commonly assigned. Only the compositional adjustments discussed above are required to employ the Strom procedures.

Preferred procedures for preparing M-IIA-C-O layers is similar to that set out in Mir et al U.S. Patent 4,880,770, except that M-IIA-C-O is substituted for rare earth alkaline earth copper oxide (therein also referred to as RAC) and firing and cooling conditions are modified as described below.

These preferred procedures for forming M-IIA-C-O layers are similar, except for the compositional improvements noted above, to the procedures described in Agostinelli et al European Serial No. 89103953.9, filed Mar. 7, 1989, for forming heavy pnictide mixed alkaline earth cooper oxide (therein also referred to as PAC) layers. To form a precursor layer onto a selected substrate is coated a solution consisting essentially of a volatilizable film forming solvent and metal-ligand compounds of each of the metals M, IIA, and Cu containing at least one thermally decomposable ligand. The solvent and ligands are removed from the substrate by heating in the presence of oxygen to form an initial mixture of the metals, which may be in the form of an oxide or an oxide intermediate (e.g., a carbonate). Heating to a high temperature is then undertaken to complete conversion of any intermediates to oxides and to convert the resulting M-IIA-C-O layer to the desired conductive crystalline form.

The first step toward conductive article formation is, of course, substrate selection. Preferred substrates are those inert toward or at least minimally interactive with the M-IIA-C-O layer. It is generally preferred to select substrates from among materials which exhibit the same or a similar crystalline form, such as a perovskite crystalline form. Lanthanum gallate ($LaGaO_3$), lanthanum aluminate ($LaAlO_3$), and potassium tantalate ($KTaO_3$) are examples of perovskite crystalline substrates. Alkaline earth oxides and zirconia constitute particularly preferred classes of substrates. They are in general relatively inert, refractory materials which exhibit limited interaction with the M-IIA-C-O layers during their formation. Magnesium oxide and strontium titanate (a perovskite) are examples of readily available alkaline earth oxide substrate materials. As employed herein the term "alkaline earth oxide substrate" is employed to indicate substrates that are comprised of alkaline earth oxides. The lower firing temperatures made possible by the inclusion of lead also make the use of polycrystalline and monocrystalline alumina attractive.

It is recognized that the selection of substrates can be broadened by employing barrier layers and/or repeating the film forming sequence so that earlier formed layers in effect serve as a substrate for later formed M-IIA-C-O layers. Both of these variations are taught by Mir et al U.S. Patent 4,880,770, cited above. Other barrier layer arrangements, such as those disclosed by Agostinelli et al European Serial No. 88111877.2, filed Mar. 7, 1989, and Sung et al U.S. Patent 4,708,348, both commonly assigned, are also specifically contemplated. For example, in employing silicon as a substrate it is specifically contemplated to employ zirconia, alkaline earth oxides such as magnesia, gold, and silver as barrier layer materials. A preferred combination is provided by a silicon substrate and a triad of barrier layers, the barrier layer nearest the silicon support being silica, the barrier layer farthest from the silicon support being a Group 4 metal oxide (preferably zirconia), and the interposed barrier layer being a mixture of silica and zirconia.

To form the precursor layer a solution of a film forming solvent, a bismuth compound, optionally a lead compound, at least two alkaline earth metal compounds, and a copper compound is prepared. Each of the compounds consists of metal ion and one or more volatilizable ligands. Most useful metal-ligand compounds (e.g., metalorganic compounds) thermally decompose to form metal oxides. Some metal compounds, in particular some alkaline earth organic compounds, can form metal carbonates on decomposition, which can then be converted to oxides during heating to crystallization temperatures. A ligand oxygen atom bonded directly to a metal is often retained with the metal in the M-IIA-C-O layer, although other ligand oxygen atoms are generally removed. Typically the ligands and their component atoms other than oxygen are outgassed at temperatures of less than 600°C. On the other hand, to avoid loss of materials before or during initial coating of the metal-ligand compounds, it is preferred that the ligands exhibit limited, if any, volatility at ambient temperatures. Metal-ligand compounds having any significant volatility below their decomposition temperature are preferably avoided.

Metalorganic (including metallo-organic and organometallic) compounds, such as metal alkyls, alkoxides, $\beta$-diketone derivatives, and metal salts of organic acids-e.g., carboxylic acids, constitute preferred metal-ligand compounds for preparing PAC precursor coatings. The number of carbon atoms in the organic ligand can vary over a wide range, but is typically limited to less than 30 carbon atoms to avoid unnecessarily reducing the proportion of metal ions present. Carboxylate ligands are particularly advantageous in promoting metal-ligand solubility. While very simple organic ligands, such as oxalate and acetate ligands, can be employed in one or more metal-ligands compounds, depending upon the film forming solvent and other metal-ligand compound choices, it is generally preferred to choose organic ligands containing at least 4 carbon atoms. The reason for this is to avoid crystallization of the metal-ligand compound and to improve solubility. When heating is begun to remove the film forming solvent and ligands, the solvent usually readily evaporates at temperatures well below those required to remove the ligands. This results in leaving the metal-ligand compounds on the substrate surface. When the ligands have few carbon atoms or, in some instances, linear carbon atom chains, crystallization of the metal-ligand compounds occurs. In extreme cases crystallization is observed at room temperatures. This works against the molecular level uniformity of heavy pnictide, alkaline earth, and copper sought by solution coating. Choosing organic ligands exhibiting 4 or more carbon atoms, preferably at least 6 carbon atoms, and, preferably, ligands containing branched carbon atom chains, reduces molecular spatial symmetries sufficiently to avoid crystallization. Optimally organic ligands contain from about 6 to 20 carbon atoms.

Instead of increasing the molecular bulk or modifying the chain configuration of organic ligands to avoid any propensity toward metalorganic compound crystallization on solvent removal, another technique which can be employed is to incorporate in the film forming solvent a separate compound to act as a film promoting agent, such as a higher molecular weight branched chain organic compound. This can, for example, take the form of a branched chain hydrocarbon or substituted hydrocarbon, such as a terpene having from about 10 to 30 carbon atoms.

The film forming solvents can be chosen from a wide range of volatilizable liquids. The primary function of the solvent is to provide a liquid phase permitting molecular level intermixing of the metalorganic compounds chosen. The liquid is also chosen for its ability to cover the substrate uniformly. Thus, an optimum film forming solvent selection is in part determined by the substrate chosen. Generally more desirable film forming properties are observed with more viscous solvents and those which more readily wet the substrate alone, or with an incorporated wetting agent, such as a surfactant, present.

It is appreciated that a wide variety of ligands, film promoting agents, and film forming solvents are available and can be collectively present in a virtually limitless array of composition choices.

Exemplary preferred organic ligands for metal organic compounds include metal 2-ethylhexanoates, naphthenates, neodecanoates, butoxides, isopropoxides, rosinates (e.g., abietates), cyclohexanebutyrates, and acetylacetonates, where the metal can be any of M, IIA, or Cu to be incorporated in the M-IIA-Cu-O layer. Exemplary preferred film forming agents include 2-ethylhexanoic acid, rosin (e.g., abietic acid), ethyl lactate, 2-ethoxyethyl acetate, and pinene. Exemplary preferred film forming solvents include toluene, 2-ethylhexanoic acid, n-butyl acetate, ethyl lactate, propanol, pinene, and mineral spirits.

As previously noted, the metal-ligand compounds are incorporated in the film forming solvent in the proportion desired in the final crystalline PAC layer. The bismuth, lead, alkaline earth, and copper can each be reacted with the same ligand forming compound or with different ligand forming compounds. The metal-ligand compounds can be incorporated in the film forming solvent in any convenient concentration up to their saturation limit at ambient temperature. Generally a concentration is chosen which provides the desired crystalline M-IIA-Cu-O layer thickness for the process sequence. Where the geometry of the substrate permits, uniformity and thickness of the metal-ligand coating can be controlled by spinning the substrate after coating around an axis normal to the surface of the substrate which has been coated. A significant advantage of spin coating is that the thickness of the coating at the conclusion of spinning is determined by the contact angle and viscosity of the coating composition and the rate and time of spinning, all of which can be precisely controlled. Differences in the amount of the coating composition applied to the substrate are not reflected in the thickness of the final coating. Centrifugal forces generated by spinning cause excess material to be rejected peripherally from the article.

The formation of the desired higher onset transition phase ($T_c$ at least 110°K, crystal cell c axis 37Å) can be enhanced by appropriately choosing firing temperatures and times. It is preferred to employ firing temperatures ranging from 840 to 910°C (optimally 850 to 900°C) and firing times ranging from 2 to 200 hours (optimally from 6 to 100 hours). The time and temperature of firing are to some extent complementary. Hence, the shorter firing times are generally employed with the higher firing temperatures and the longer firing times with the lower firing temperatures. The object in firing is to form a solidus mixture of liquid and solid phases in equilibrium that facilitates phase formation, crystal growth, and orientation.

M-IIA-C-O layer crystallization can be undertaken in any convenient oxidizing atmosphere, including oxygen or oxygen contained in a convenient carrier, such as argon or air. The crystalline M-IIA-C-O layers show little response to variances in cooling and/or annealing following crystal formation.

Examples

The invention can be better appreciated by reference to the following specific embodiments of the invention:

Control 1

A first precursor solution P1 (Bi:Sr:Ca:Cu = 2:2:2:3) was prepared from the following materials:
2.6 g of 2-ethylhexanoic acid solution of bismuth acetate (salt source: Alfa #17574TM) containing 18.6 weight percent bismuth;
4.6 g of 2-ethylhexanoic acid solution of calcium 2-ethylhexanoate (salt source: Eastman Kodak #10124TM) containing 2.0 weight percent of calcium;
3.5 g of 2-ethylhexanoic acid solution of copper; acetate (salt source: J.T. Baker 1766-1TM) containing 6.4 weight percent copper;
1.06 g of strontium cyclohexanebutyrate powder (source Eastman Kodak #IO4I3TM) containing 19.4 weight percent of strontium; and
2.0 g of rosin.
The preparation of precursor solution P1 was completed by refluxing for one minute, cooling to room temperature, and then filtering using a 1.2 μm filter.

A coating of the precursor solution P1 was spin coated onto the {100} face of a monocrystalline magnesia wafer at 4000 rpm for 20 seconds. The P1 coating was heated in air to 450°C on a hot plate and then heated in oxygen to 650°C in a Fisher Model 495TM ashing furnace to volatilize the organic components of P1. The coating and heating steps were performed a total of five times in sequence.

The resulting mixed bismuth oxide, strontium carbonate, calcium carbonate, and copper oxide layer was converted to an electrically conductive crystalline bismuth strontium calcium copper oxide (BSCCO) superconductive film by heating in oxygen to 900°C in the ashing furnace. The sample was held at this temperature for 12 hours and then allowed to cool slowly at a rate of 6°C per minute. After cooling to room temperature the sample was heated in oxygen to 450°C, left to anneal at this temperature for 1 hour, and then allowed to cool slowly at a rate of 6°C per minute.

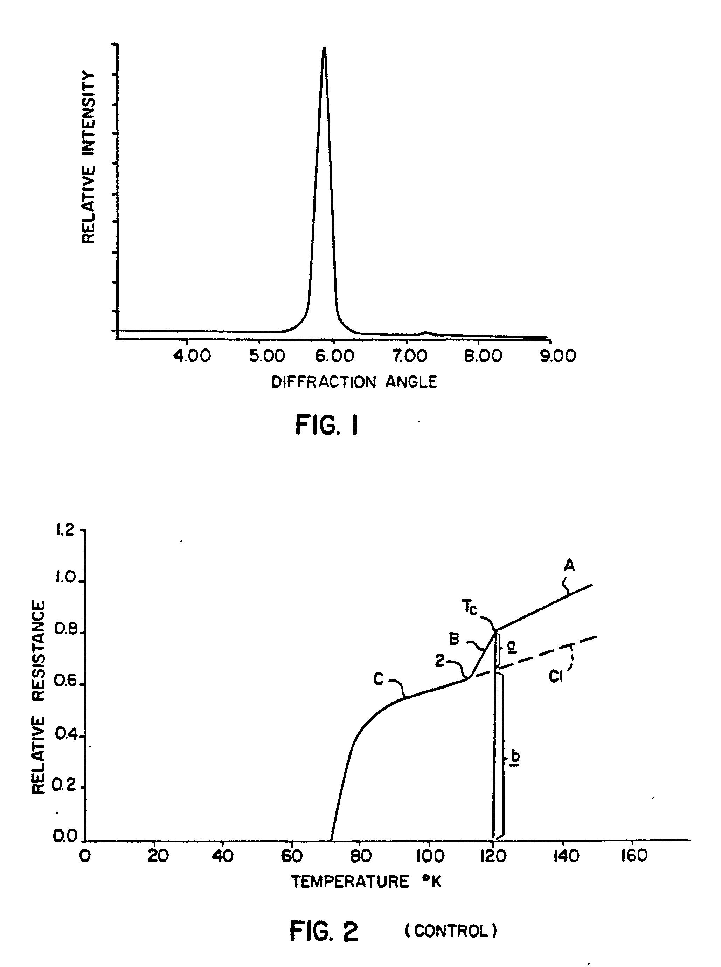

The X-ray diffraction pattern of the BSCCO is shown in Figure 1. The diffraction peak at 5.8° corresponds to the (002) line accounted for by the phase of the pseudotetragonal layered structure with a c axis crystal cell dimension of 30.7Å and an onset transition temperature $T_c$ of 85°K.

A standard four probe technique was used to measure film resistance as a function of temperature. Contacts were made using gold-bonding pads fabricated by pyrolysis of a gold organometallic precursor (source: Englehard Liquid Bright GoldTM).

Figure 2 provides a curve of normalized resistance versus temperature in °K for the conductive article prepared as described above. A first segment A of the curve extending from 160°K to a first onset transition temperature $T_c$ shows a gradual, linear decrease in resistivity as a function of temperature. On further cooling, resistance at first declined rapidly, as indicated by segment B of the curve, which extends from $T_c$ to point 2. On still further cooling resistance resumed a linear rate of decline, indicated by the linear portion of curve segment C, approximating the rate of decline above $T_c$, until a second onset transition temperature (less sharply defined) occurred in the vicinity of 85°K.

From the two different onset transition temperatures exhibited by the curve it is apparent that the BSCCO layer of the conductive article is made up of at least two phases. Further, the higher onset transition phase is not present in a proportion sufficient to itself provide a continuous conduction path, otherwise the relative resistance of the BSCCO layer would drop to zero at a temperature above the second, 85°K onset transition temperature. The contribution of the higher onset transition phase to current conduction in the BSCCO film can be assessed by comparing relative resistances of the film at $T_c$ and a lower temperature, where the higher onset transition phase has become superconductive, but the lower onset transiton phase has not reached its onset transition temperature. This is carried out by extrapolating from the linear portion of curve segment C, as indicated by dashed line C1, to the temperature $T_c$. The resistance fraction a (also referred to as the transition depth) lying between $T_c$ and the intersection of C1 accounts for only 19 percent of the total resistance, the sum of a, the resistance fraction or transition depth above extrapolation C1 and b, the resistance fraction below extrapolation C1. The lower the transition depth, the lower the contribution of the higher onset transition phase to current conduction.

### Control 2

Control 1 was repeated, except that a precursor solution P2 was employed with the proportion of bismuth increased to satisfy the ratio Bi:Sr:Ca:Cu of 2.6:2:2:3. The diffraction curve was similar to Figure 1. An analysis of the curve of temperature versus normalized resistance, similar to that described in connection with Figure 2, indicated that the transition depth of the higher onset transition phase was only 34 percent.

### Control 3

A third precursor solution P3 (Bi:Sr:Ca:Cu = 2.3:2:2:3) was prepared from the following materials:
3.11 g of 2-ethylhexanoic acid solution of bismuth acetate (salt source: Alfa #17574TM) containing 20.9 weight percent bismuth;
.2.15 g of 2-ethylhexanoic acid solution of calcium 2-ethylhexanoate (salt source: Eastman Kodak #10124TM) containing 5 weight percent of calcium;
4.0 g of 2-ethylhexanoic acid solution of copper acetate (salt source: J.T. Baker 1766-1TM) containing 6.4 weight percent copper;
1.22 g of strontium cyclohexanebutyrate powder (source Eastman Kodak #10413TM) containing 19.4 weight percent of strontium; and
0.82 g of rosin.
The preparation of precursor solution P1 was completed by refluxing for one minute, cooling to room temperature, and then filtering using a 1.2 μm filter.
Coating and heating of the precursor solution P3 was performed as described in Example 1 to form a crystalline film 2 μm in thickness, but with heating in oxygen to 900°C in the ashing furnace being extended from 12 to 167 hours.

The X-ray diffraction curve, like that of Figure 1 exhibited a peak at a deflection angle of 5.8°, but no peak at 4,9°,

An analysis of the curve of temperature versus normalized resistance, similar to that described in connection with Figure 2, indicated that the transition depth of the higher onset transition phase was only 10 percent.

Example 4

Control 3 was repeated, except that a precursor solution P4 was employed with the proportion of bismuth increased to satisfy the ratio Bi:Sr:Ca:Cu of 3.2:2:2:3.

The X-ray diffraction pattern of the BSCCO differed from that of Figure 1 by showing a pronounced diffraction peak at 4.9°, which corresponds to the (002) line accounted for by the phase of the pseudotetragonal layered structure with a c axis crystal cell dimension of 37Å and the higher onset transition temperature $T_c$ of 110° K.

An analysis of the curve of temperature versus normalized resistance, similar to that described in connection with Figure 2, indicated that the transition depth of the higher onset transition phase had increased to 87 percent. In other words, when the higher onset transition phase became superconductive, 87 percent of the resistance of the BSCCO layer was eliminated.

Examples 5-7

Control 3 was repeated, except that the sintering time was reduced to 6 hours at 900° C and the proportion of bismuth was increased, as indicated in Table 1 below.

Table I

| Example | Bi | Sr | Ca | Cu | Trans. Depth (%) |
|---|---|---|---|---|---|
| 5 | 3.10 | 2 | 2 | 3 | 43 |
| 6 | 3.33 | 2 | 2 | 3 | 60 |
| 7 | 4.0 | 2 | 2 | 3 | 100 |

Note that the transition depth was in each instance larger than that observed when Bi:Cu was not greater than 1.00 in the controls above.

Example 7 differed from the other coatings in that the higher onset transition phase was present in an amount sufficient to itself provide a continuous conduction path through the BSCCO film. Thus, when the higher onset transition phase was cooled to its superconducting temperature, all of the current followed the zero resistance conduction path provided by the higher onset transition phase.

Example 8

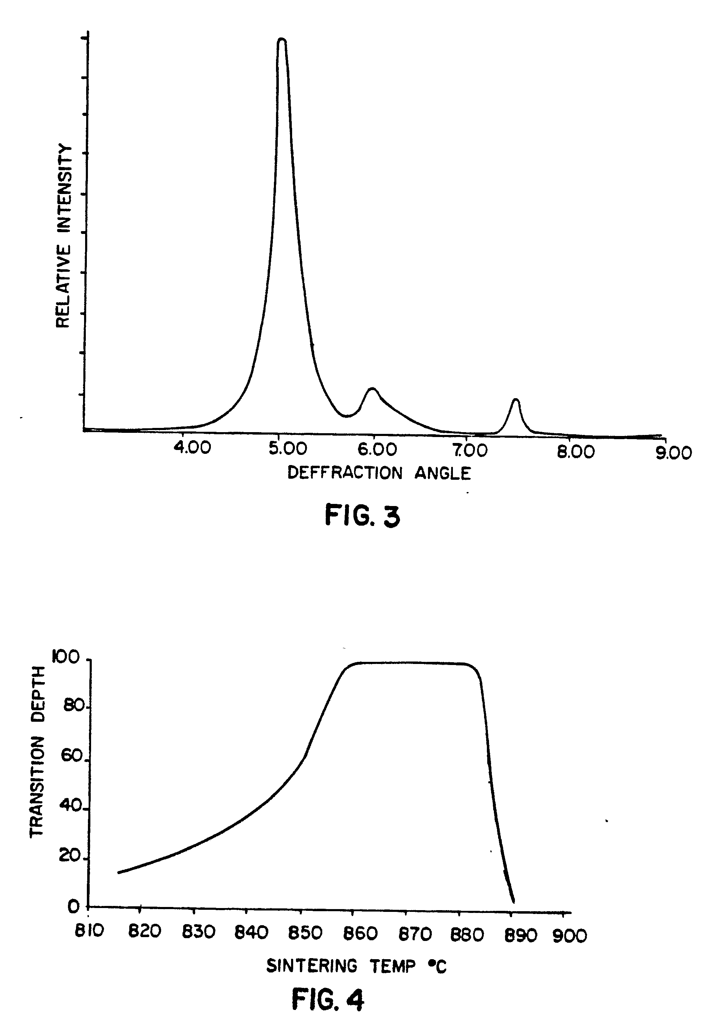

Example 4 was repeated, except that only four repetitions of coating and heating were undertaken before sintering and the sintering time at 900° C was 12 hours. The transition depth was observed to be 100 percent, indicating an increased proportion of the higher onset transition phase. This was confirmed by X-ray diffraction analysis. Referring to Figure 3, it can be seen that the highest intensity diffraction peak was at 4.9°, which corresponds to the (002) line accounted for by the phase of the pseudotetragonal layered structure with ac axis crystal cell dimension of 37Å and the higher onset transition temperature $T_c$ of 110° K.

Controls 9-11

Example 8 was repeated, but with bismuth, strontium, calcium, and copper being present in the ratio Bi:Sr:Ca:Cu of 2.0:2:2:3. The following results were observed:

Table II

| Transition Depth (%) | Sintering Temperature ($^\circ$C) |
|---|---|
| 5 | 880 |
| 10 | 900 |
| 20 | 908 |

Controls 12-17

Example 8 was repeated, but with bismuth, lead, strontium, calcium, and copper being present in the ratio M(Bi + Pb):Sr:Ca:Cu of 2.0(1.6 + 0.4):2:2:3 and the sintering temperatures being varied. Lead was supplied in the form of lead 2-ethylhexanoate, forming by combining lead acetate (source: Eastman Kodak EK 1975TM) with 2-ethylhexanoic acid. The transition depth remained at less than 5 percent at sintering temperatures of 873, 880, 888, 894, 900, and 907$^\circ$C. The introduction of lead thus appeared to be have deleterious, actually worsening the results obtained with Controls 9-12.

Examples 18-22

Controls 12-17 were repeated, but with bismuth, lead, strontium, calcium, and copper being present in the ratio M(Bi + Pb):Sr:Ca:Cu of 4.8(3.2 + 1.6) 2:2:3 and the sintering temperatures being varied.

Referring to Figure 4, it is apparent that at firing temperatures of from 855 to 885$^\circ$C the transition depth remained near 100 percent, indicating formation of the higher onset transition phase at its superconducting temperature carried all or almost all of the BSCCO film current. With lead omitted from the formulation a transition depth of near 100 percent was achieved at a sintering temperature of 900$^\circ$C with significant reductions in transition depth at both higher and lower sintering temperatures. Thus, the effect of lead addition to the Bi:Cu > 1.00 material was to broaden the range of sintering temperatures available for achieving 100 percent and near 100 percent transition depths and to reduce optimum sintering temperatures. When the transition depth was 100 percent, superconductivity ($T_o$) was observed at temperatures above 85$^\circ$K.

**Claims**

1. A process of forming on a substrate a conductive film having a $T_c$ of at least 110$^\circ$K comprising forming a bismuth mixed alkaline earth copper oxide on the substrate satisfying the ratio:

Cu:IIA is > 0.70

where

IIA represents atoms of alkaline earth elements and

converting at least a portion of the bismuth mixed alkaline earth copper oxide to a crystalline conductive phase exhibiting 5.4Å, 5.4Å, and 37Å crystal cell a, b, and c crystal axes, respectively,

characterized in that the proportion of the film accounted for by the 37Å crystalline conductive phase is increased by increasing the proportion of bismuth or bismuth in combination with lead in the bismuth mixed alkaline earth copper oxide to satisfy the metal ratio:

M:Cu is > 1.00

where

M is bismuth and 0 to 50 percent lead, based on bismuth and lead combined.

2. A process according to claim 1 further characterized in that the ratio of M:Cu is in the range of from 3.1:3 to 10:3.

3. A process according to claim 2 further characterized in that the ratio of M:Cu is in the range from

9

3.15:3 to 6:3.

4, A process according to claim 3 further characterized in that the ratio of M:Cu is in the range from 3.5:3 to 4.3:3.

5. A process according to any one of claims 1 to 4 inclusive further characterized in that the oxide is converted to the crystalline conductive phase by heating to a temperature in the range of from 840 to 910°C for a period of from 2 to 200 hours in an oxygen containing atmosphere.

6. A process according to claim 5 further characterized in that the oxide is converted to the crystalline conductive phase by heating to a temperature in the range from 850 to 900°C for a period of from 6 to 100 hours.

7. A process according to claim 6 further characterized in that the oxide is converted to the crystalline conductive phase by heating to a temperature in the range from 855 to 885°C for a period of from 6 to 100 hours.

8. A process according to any one of claims 1 to 7 inclusive further characterized in that the bismuth mixed alkaline earth copper oxide contains a combination of calcium and strontium, with from 0 to 10 percent barium being substituted for strontium, based on barium and strontium combined.

9. A process according to any one of claims 1 to 8 inclusive further characterized in that M is at least 5 percent lead, based on bismuth and lead combined.

10. A process according to claim 9 further characterized in that M is from 10 to 40 percent lead, based on bismuth and lead combined.

11. A process according to any one of claims 1 to 10 inclusive further characterized in that
IIA is a combination of the alkaline earth elements A and Ca in a ratio of from 1:3 to 3:1 and
A is strontium and 0 to 10 percent barium, based on barium and strontium combined.

12. A process according to any one of claims 1 to 11 inclusive further characterized in that the substrate is monocrystalline magnesia and the conductive film is located on a {100} crystal face of the magnesia substrate.

13. An article prepared by the process of any one of claims 1 to 12 inclusive.

EP 0 396 478 A2

FIG. I

FIG. 2  (CONTROL)

FIG. 3

FIG. 4